# EUROPÄISCHE PATENTANMELDUNG

(11) **EP 4 084 058 A1**
(43) Veröffentlichungstag der Anmeldung: **02.11.2022**
(21) Anmeldenummer: 21170578.5
(22) Anmeldetag: 27.04.2021
(51) Int. Cl.: H01L 23/367, H01L 23/373, H01L 25/07

(54) **ELEKTRONIK-BAUGRUPPE MIT SCHALTUNGSTRÄGER, HALBLEITERCHIP UND KÜHLKÖRPER**

(71) Anmelder: Siemens Aktiengesellschaft, 80333 München (DE)
(72) Erfinder: Feil, Wolfgang, 92421 Schwandorf (DE); Kiefl, Stefan, 80992 München (DE); Schaller, Karl-Heinz, 92289 Ursensollen (DE); Stegmeier, Stefan, 81825 München (DE); Wöllmer, Heinz, 92260 Ammerthal (DE)

(57) **Zusammenfassung**

Es wird eine Elektronik-Baugruppe (1) mit wenigstens einem Schaltungsträger (10a,10b,10c), wenigstens einem Halbleiterchip (20a,20b) und wenigstens einem Kühlkörper (30) angegeben,
- wobei die Elektronik-Baugruppe (1) eine flächige Grundform mit einer Hauptebene (P) aufweist und insbesondere zum Einbau in eine übergeordnete Vorrichtung vorgesehen ist,
- wobei der wenigstens eine Schaltungsträger (10a,10b,10c) parallel zur Hauptebene (P) orientiert ist und einen oder mehrere Halbleiterchips (20a,20b) trägt, mit denen er flächig verbunden ist,
- wobei in einem ersten Randbereich (R1) der flächigen Elektronik-Baugruppe (1) der wenigstens eine Kühlkörper (30) angeordnet ist,
- und wobei der wenigstens eine Schaltungsträger (10a,10b,10c) zwischen dem Bereich des wenigstens einen Halbleiterchips (20a,20b) und dem ersten Randbereich (R1) wenigstens eine Dickschicht-Leiterbahn (11,13,16) aufweist, die Teil eines Haupt-Entwärmungspfades (H) ist, welcher im Wesentlichen parallel zur Hauptebene (P) verläuft.

Weiterhin wird eine Vorrichtung mit einer solchen Elektronik-Baugruppe (1) angegeben.

## Beschreibung

Die vorliegende Erfindung betrifft eine Elektronik-Baugruppe mit wenigstens einem Schaltungsträger, wenigstens einem Halbleiterchip und wenigstens einem Kühlkörper, wobei die Elektronik-Baugruppe zum Einbau in eine übergeordnete Vorrichtung vorgesehen ist. Weiterhin betrifft die Erfindung eine Vorrichtung mit einer solchen Elektronik-Baugruppe.

Aus dem Stand der Technik sind zahlreiche unterschiedliche Elektronik-Baugruppen bekannt, bei denen ein oder mehrere Halbleiterchips auf einem Schaltungsträger angeordnet sind, und bei denen ein Kühlkörper vorgesehen ist, um die beim Betrieb erzeugte Wärme abzuführen. Vor allem bei den leistungselektronischen Elektronik-Baugruppen stellt die effektive Entwärmung der Halbleiterchips eine große Herausforderung dar, weil die Leistungsdichten immer höher werden und daher immer mehr Wärme auf immer kleinerem Raum zuverlässig an die Umgebung abgeleitet werden muss, um eine Überhitzung der Baugruppen zu vermeiden.

Nach dem Stand der Technik werden leistungselektronische Baugruppen typischerweise in einer horizontalen Schichtfolge aufgebaut. Genauer gesagt wird dabei ein Kühlkörper großflächig mit einem flächigen Schaltungsträger verbunden, und der Schaltungsträger wird auf seiner gegenüberliegenden Seite wiederum flächig mit den darauf aufgebrachten Halbleiterchips verbunden. In diesem Aufbau liegen entsprechend die Hauptflächen von Kühlkörper, Schaltungsträger und Halbleiterchip parallel zueinander, und es ist ein Haupt-Entwärmungspfad gegeben, der senkrecht zu diesen Hauptflächen liegt. Ein Vorteil dieses herkömmlichen horizontalen Aufbaus ist, dass durch die flächige Anbindung von Halbleiterchip zum Schaltungsträger und von Schaltungsträger zum Kühlkörper jeweils ein effektiver Wärmeübergang realisiert werden kann, und bei entsprechend geringer Dicke und großer Fläche des Schaltungsträgers auch eine effektive Wärmeleitung durch diesen hindurch gegeben ist. Dabei kann gleichzeitig eine gute Durchschlagsfestigkeit erreicht werden.

Nachteilig bei diesem großflächig gekoppelten horizontalen Aufbau nach dem Stand der Technik ist, dass eine solche Elektronik-Baugruppe bei ihrem Einbau in eine übergeordnete Vorrichtung relativ viel lateralen Einbauplatz innerhalb der Einbauebene benötigt. Dies liegt daran, dass die Entwärmungsrichtung senkrecht zur Schichtebene liegt und die freigesetzte Wärme in dieser Richtung an die äußere Umgebung abgegeben werden muss. Der Kühlkörper muss also auf seiner ganzen Außenfläche zur äußeren Umgebung hin zugänglich sein, um z.B. von einem Kühlluftstrom angeströmt zu werden. Daher ist bei dieser Art des Aufbaus der minimale Flächenbedarf typischerweise durch die Grundfläche des Kühlkörpers oder auch des Schaltungsträgers vorgegeben, je nachdem welches dieser Elemente die größere Grundfläche aufweist. Meist wird dann noch zusätzliche Einbaufläche für die Lastanschlüsse und Steuerleitungen benötigt. Bei vielen Anwendungen ist jedoch der insgesamt zur Verfügung stehende Einbauplatz begrenzt. Zum Beispiel stehen in einem Schaltschrank nur eine begrenzte Zahl von Steckplätzen von jeweils limitierter Größe für den Einbau solcher Baugruppen zur Verfügung. Gerade bei Vorrichtungen mit leistungselektronischen Baugruppen ist es schwierig, eine zuverlässige Wärmeabfuhr zu erreichen und trotzdem den Bauraum klein zu halten, da die Leistung solcher Baugruppen und damit die freigesetzte Wärme zunehmend größer wird.

Aufgabe der Erfindung ist es daher, eine Elektronik-Baugruppe anzugeben, welche den genannten Nachteil überwindet. Insbesondere soll eine Elektronik-Baugruppe zur Verfügung gestellt werden, welche einen vergleichsweise geringen Platzbedarf innerhalb der Einbauebene einer übergeordneten Vorrichtung aufweist und trotzdem effektiv entwärmt werden kann. Eine weitere Aufgabe ist es, eine übergeordnete Vorrichtung mit einer solchen Elektronik-Baugruppe anzugeben.

Diese Aufgaben werden durch die in Anspruch 1 beschriebene Elektronik-Baugruppe und die in Anspruch 15 beschriebene Vorrichtung gelöst.

Die erfindungsgemäße Elektronik-Baugruppe weist einen Schaltungsträger, wenigstens einen Halbleiterchip und wenigstens einen Kühlkörper auf. Sie weist eine flächige Grundform mit einer Hauptebene auf und ist insbesondere zum Einbau in eine übergeordnete Vorrichtung vorgesehen. Der wenigstens eine Schaltungsträger ist im Wesentlichen parallel zu der Hauptebene orientiert und trägt einen oder mehrere Halbleiterchips, mit denen er flächig verbunden ist. In einem ersten Randbereich der flächigen Elektronik-Baugruppe ist der wenigstens eine Kühlkörper angeordnet. Der wenigstens eine Schaltungsträger weist zwischen dem Bereich des wenigstens einen Halbleiterchips und dem ersten Randbereich wenigstens eine Dickschicht-Leiterbahn auf, die Teil eines Haupt-Entwärmungspfades ist, welcher im Wesentlichen parallel zu der Hauptebene der Elektronik-Baugruppe verläuft.

Bei den Ausführungsformen, bei denen die Elektronik-Baugruppe mehrere Schaltungsträger umfasst, sollen insbesondere alle vorhandenen Schaltungsträger parallel zu der Hauptebene orientiert sein. Auch die flächig mit dem jeweiligen Schaltungsträger verbundenen Halbleiterchips sind dann parallel zu dieser Hauptebene orientiert. Insgesamt ergibt sich so ein sandwichartiger Schichtaufbau mit ein oder mehreren flächigen Schaltungsträgern und ein oder mehreren flächigen Halbleiterchips. Der wenigstens eine Kühlkörper ist dabei in einem Randbereich dieses mehrschichtigen Aufbaus angeordnet. Die durch den Kühlkörper vermittelte Abfuhr von Wärme an die äußere Umgebung findet dadurch überwiegend in diesem ersten Randbereich statt und nicht auf der ganzen Fläche der Baugruppe. Dabei soll nicht ausgeschlossen sein, dass sich Teilstücke des Kühlkörpers über einen größeren Teil der Oberfläche der Baugruppe erstrecken. Die für die Entwärmung an die äußere Umgebung relevanten Teilelemente (z.B. Kühlrippen, Kühlstege, Kühlfinnen, Kühlnadeln oder vergleichbare Strukturen) sollen aber auf den ersten Randbereich konzentriert sein, so dass hier der überwiegende Teil der Wärmeabgabe an die Umgebung erfolgt.

Um die vom Kühlkörper an die Umgebung abzugebende Wärme in den Bereich des Kühlkörpers zu leiten, ist innerhalb der Baugruppe der genannte Haupt-Entwärmungspfad ausgebildet. Wesentlich im Zusammenhang mit der vorliegenden Erfindung ist, dass dieser Haupt-Entwärmungspfad im Wesentlichen parallel zu der Hauptebene der Baugruppe liegt und nicht, wie bei dem beschriebenen Stand der Technik, senkrecht zu dem Schichtaufbau. Der genannte Haupt-Entwärmungspfad kann auch aus mehreren Teilpfaden zusammengesetzt sein, insbesondere wenn die Baugruppe mehrere Halbleiterchips aufweist, von denen die Wärme jeweils zu einem gemeinsamen Kühlkörper weitergeleitet werden muss. Die zu den jeweiligen Halbleiterchips zugeordneten Teilpfade können dann jedoch in einen gemeinsamen Entwärmungspfad münden. Wesentlich ist, dass dieser gemeinsame Entwärmungspfad überwiegend innerhalb der Hauptebene der Baugruppe verläuft. Weiterhin soll in diesem Zusammenhang nicht ausgeschlossen sein, dass die einzelnen Teilpfade (im Bereich neben den Halbleiterchips) sowie auch der daraus gebildete gemeinsame Entwärmungspfad kleinere lokale Teilabschnitte mit einer Wärmeflussrichtung aufweisen, die senkrecht zur Hauptebene liegt. Wesentlich ist im Zusammenhang mit der vorliegenden Erfindung nur, dass die übergeordnete Richtung der Wärmeabfuhr (also die Netto-Transportrichtung für die abgeleitete Wärme) durch eine insgesamt überwiegende Richtungskomponente innerhalb der genannten Hauptebene gekennzeichnet ist. Eine kleiner Winkel in der Netto-Transportrichtung und der Hauptebene von beispielsweise bis zu 10° soll dabei grundsätzlich nicht ausgeschlossen sein.

Diese innerhalb der Hauptebene liegende Richtung des Haupt-Entwärmungspfades wird dadurch erreicht, dass der jeweilige Schaltungsträger in dem relevanten Bereich zwischen einem gegebenen Halbleiterchip und dem jeweils zugeordneten Kühlkörper eine Dickschicht-Leiterbahn aufweist. Unter einer Dickschicht-Leiterbahn soll dabei allgemein eine Leiterbahn verstanden werden, die eine Schichtdicke von wenigstens 300 µm aufweist. Die Schichtdicke ist dabei die Abmessung der Leiterbahn senkrecht zur Hauptebene. Insbesondere kann eine solche Schichtdicke oberhalb von 1 mm liegen, beispielsweise in einem vorteilhaften Bereich zwischen 1 mm und 4 mm. Diese Dickschicht-Leiterbahn kann insbesondere aus einem metallischen Material gebildet sein, beispielsweise aus Kupfer, Aluminium, Molybdän oder einer Legierung aus einem oder mehreren der genannten Metalle. Allgemein ist dabei eine kupfer-basierte Dickschicht-Leiterbahn besonders bevorzugt.

Insbesondere ist jeder der vorhandenen Halbleiterchips über eine solche Dickschicht-Leiterbahn mit einem zugeordneten Kühlkörper verbunden. Durch diese zugeordnete Dickschicht-Leiterbahn ist ein Wärmeleitungspfad gegeben, welcher den Bereich des jeweiligen Halbleiterchips mit dem Bereich des zugeordneten Kühlkörpers wärmeleitend verbindet und parallel zur Hauptebene liegt (nämlich in der Ebene des jeweiligen Schaltungsträgers). Aufgrund der besonders hohen Schichtdicke dieser Leiterbahn wird so ein effektiver Wärmetransport innerhalb der Hauptebene erreicht, so dass die im Bereich des Halbleiterchips erzeugte Wärme effektiv in den ersten Randbereich weitergeleitet werden kann und dort vom Kühlkörper an die äußere Umgebung abgegeben werden kann.

Es können insgesamt mehrere solche Dickschicht-Leiterbahnen in der Baugruppe vorliegen. Diese Dickschicht-Leiterbahnen können neben ihrer Funktion als Wärmepfad außerdem für eine elektrische Anbindung des jeweiligen Halbleiterchips genutzt werden. Dies ist jedoch nicht zwingend erforderlich. So kann diese theoretisch mögliche Doppel-Funktionalität entweder für alle oder auch nur für einen Teil der vorhandenen Dickschicht-Leiterbahnen genutzt werden - je nach Bedarf für die elektrische Anbindung. Vorteilhaft erfüllt aber zumindest einer der vorhandenen Schaltungsträger eine Doppelfunktion, indem durch ihn sowohl die elektrische Anbindung als auch die Entwärmung des zugehörigen Halbleiterchips realisiert wird.

Ein wesentlicher Vorteil der erfindungsgemäßen Ausgestaltung liegt darin, dass aufgrund des innerhalb der Hauptebene liegenden Entwärmungspfades ein Einbau in eine übergeordnete Vorrichtung ermöglicht wird, bei dem die Elektronik-Baugruppe von einem Grundträger der Vorrichtung absteht. Mit anderen Worten ist dann die Hauptebene der Elektronik-Baugruppe nicht wie beim Stand der Technik parallel zu einer Einbauebene der Vorrichtung orientiert, sondern erstreckt sich weg von dem zugeordneten Einbauplatz, insbesondere in einem senkrechten oder schrägen Winkel. Durch den innerhalb der Ebene der Baugruppe liegenden Entwärmungspfad wird bei dieser Anordnung eine effektive Entwärmung ermöglicht und zwar durch einen Kühlkörper, der insbesondere in einem von dem Einbauplatz abgewandten Randbereich der Baugruppe liegt. Durch diese vom Einbauplatz weg ragende Ausrichtung der Baugruppe wird einerseits erreicht, dass der Einbauplatz nur eine relativ geringe Fläche innerhalb der Einbauebene verbraucht. Andererseits wird durch den mit der Dickschicht-Leiterbahn geschaffenen Entwärmungspfad trotzdem eine effektive Entwärmung zur äußeren Umgebung gewährleistet. Insgesamt können daher mit dem erfindungsgemäßen Aufbau sehr kompakte Anordnungen von ein oder mehreren solchen Baugruppen in einer übergeordneten Vorrichtung realisiert werden, wobei trotzdem hohe Leistungsklassen zum Einsatz kommen können.

Die erfindungsgemäße Vorrichtung weist einen Grundträger und ein oder mehrere erfindungsgemäße Elektronik-Baugruppen auf. Durch den Grundträger ist eine Einbauebene definiert, von der ein Teilbereich als Einbauplatz für die jeweils zugeordnete Elektronik-Baugruppe ausgebildet ist. Die jeweilige Elektronik-Baugruppe steht dabei derart von dem Grundträger ab, dass die Hauptebene der Elektronik-Baugruppe einen Winkel von wenigstens 30° zur Einbauebene des Grundträgers bildet. Insbesondere steht die jeweilige Elektronik-Baugruppe im Wesentlichen senkrecht von dem Grundträger ab. Die Vorteile der übergeordneten Vorrichtung ergeben sich analog zu den bereits beschriebenen Vorteilen der erfindungsgemäßen Baugruppe.

Vorteilhafte Ausgestaltungen und Weiterbildungen der Erfindung gehen aus den von Anspruch 1 abhängigen Ansprüchen sowie der folgenden Beschreibung hervor. Dabei können die beschriebenen Ausgestaltungen der Elektronik-Baugruppe und der übergeordneten Vorrichtung allgemein vorteilhaft miteinander kombiniert werden.

So kann der Kühlkörper insbesondere eine Entwärmungsfläche ausbilden, die in einem Winkel von wenigstens 30° zur ersten Hauptfläche orientiert ist. Besonders vorteilhaft liegt diese Entwärmungsfläche im Wesentlichen senkrecht zur Hauptebene der Baugruppe. Unter dieser Entwärmungsfläche ist jedoch keine planare Oberfläche des Kühlkörpers zu verstehen, sondern eine Einhüllende, durch die der an die Umgebung abgeführte Wärmestrom senkrecht hindurchtritt. Gerade in diesem Bereich ist es vorteilhaft, wenn der Kühlkörper nicht eben ausgestaltet ist, sondern oberflächenvergrößernde Strukturen aufweist, wie beispielsweise Kühlrippen, Kühlstege, Kühlfinnen, Kühlnadeln oder ähnliches, um die Entwärmung an die Umgebung zu verbessern. Beispielsweise kann der Kühlkörper eine Mehrzahl von Kühlrippen aufweisen, welche sich insbesondere parallel zur Hauptebene der Baugruppe erstrecken und die Wärme so noch weiter in Richtung des Haupt-Entwärmungspfades herausleiten. Alternativ zu solchen parallelen Kühlrippen kann der Kühlkörper aber auch als Kühlstern mit schrägen und insbesondere auch in sich verzweigten Kühlungsstrukturen ausgestaltet sein.

Allgemein vorteilhaft kann die Elektronik-Baugruppe als leistungselektronische Baugruppe ausgestaltet sein. Dabei ist wenigstens einer der vorhandenen Halbleiterchips als leistungselektronisches Bauelement ausgebildet. Bei einer solchen Leistungs-Baugruppe kommen die Vorteile der Erfindung in Bezug auf den geringen Platzbedarf in der Einbauebene und die trotzdem ermöglichte effektive Entwärmung besonders wirksam zum Tragen. Als leistungselektronisches Bauelement kann dabei beispielsweise eine Leistungs-Diode und/oder ein IGBT (ein Bipolar-Transistor mit isolierter Gate-Elektrode) zum Einsatz kommen, aber auch andere aus dem Stand der Technik grundsätzlich bekannte Leistungs-Bauelemente.

Gemäß einer vorteilhaften Ausführungsform kann die Elektronik-Baugruppe mehrere Halbleiterchips aufweisen, die auf demselben Schaltungsträger angeordnet sind. Diese Halbleiterchips können bezüglich des Haupt-Entwärmungspfades nebeneinander oder hintereinander angeordnet sein, wobei auch Kombinationen dieser beiden Varianten der Anordnung möglich sind. Durch die zugeordnete Dickschicht-Leiterbahn können mehrere solche Halbleiterchips gegebenenfalls auch elektrisch miteinander verbunden sein. So kann beispielsweise eine Common-Emitter-Schaltung zwischen einer Leistungs-Diode und einem IGBT realisiert sein. Alternativ oder zusätzlich können mehrere Bauelemente auch in der Art einer Halbbrücke oder einer Vollbrücke durch ein oder mehrere Dickschicht-Leiterbahnen untereinander elektrisch verbunden sein, wobei gleichzeitig ein gemeinsamer Entwärmungspfad gebildet ist.

Allgemein vorteilhaft ist die wenigstens eine Dickschicht-Leiterbahn thermisch an den zugeordneten Kühlkörper angekoppelt. Insbesondere ist diese thermische Ankopplung so ausgestaltet, dass zwischen dem jeweiligen Halbleiterchip und dem zugeordneten Kühlkörper der insgesamt überwiegende Entwärmungspfad über die zugeordnete Dickschicht-Leiterbahn verläuft.

Bei dieser Ausführungsvariante ist es besonders bevorzugt, wenn die thermische Anbindung von wenigstens einer der vorhandenen Dickschicht-Leiterbahnen an den Kühlkörper durch eine großflächige Isolationsschicht vermittelt wird. Unter "großflächig" soll dabei eine Isolationsschicht verstanden werden, die eine Fläche aufweist, welche wenigstens so groß ist wie die Fläche der zugehörigen Dickschicht-Leiterbahn.

Die Fläche einer Dickschicht-Leiterbahn kann dabei allgemein beispielsweise oberhalb von 1 cm² liegen, insbesondere im Bereich von wenigstens 5 cm². Die Breite eine Dickschicht-Leiterbahn kann allgemein bei 1 cm oder mehr liegen. Bei dieser Dimensionierung wird vorteilhaft ein besonders effektiver Wärmetransport zum Kühlkörper gewährleistet.

Wenn zumindest an irgendeiner Stelle entlang des Entwärmungspfades eine Ankopplung über eine großflächige Isolationsschicht erfolgt, dann kann hierdurch eine elektrische Isolation zwischen dem Kühlkörper und der (ggf. auch elektrisch mit dem Halbleiterchip verbundenen) Dickschicht-Leiterbahn bewirkt werden. Je nach Spannungsklasse der Elektronik-Baugruppe können dabei unterschiedliche Schichtdicken der Isolationsschicht zum Einsatz kommen. Zum Beispiel kann die Schichtdicke unterhalb von 1 mm liegen, insbesondere in einem Bereich zwischen 25 µm und 500 µm. Mit derartigen Schichtdicken können hohe Spannungsfestigkeiten erreicht werden. Aufgrund der vergleichsweise großen Fläche kann dabei gleichzeitig eine effektive thermische Ankopplung erreicht werden, trotz der typischerweise eher geringen thermischen Leitfähigkeit von elektrisch isolierenden Materialien. Geeignete Materialien für eine solche elektrisch isolierende Kopplungsschicht sind allgemein organische Polymere, insbesondere Polyimide oder Epoxide, die gegebenenfalls auch Füllstoffe aus anderen Materialien aufweisen können, insbesondere keramische Füllstoffe zur Einstellung eines gewünschten thermischen Expansionskoeffizienten.

Allgemein kann eine solche großflächige Isolationsschicht beispielsweise zwischen einer Dickschicht-Leiterbahn eines Schaltungsträgers und einem flächigen Seitenelement eines Kühlkörpers angeordnet sein. Alternativ kann eine solche großflächige Isolationsschicht aber auch innerhalb eines Schaltungsträgers liegen, um eine elektrische Entkopplung zwischen zwei übereinanderliegenden Dickschicht-Leiterbahnen zu erreichen. Dann kann eine dieser Dickschicht-Leiterbahnen mit dem Halbleiterchip verbunden sein, und die andere kann mit dem Kühlkörper verbunden sein, wobei durch die Isolationsschicht eine elektrische Isolation zwischen dem Kühlkörper und dem Halbleiterchip erreicht wird, bei trotzdem vergleichsweise guter thermischer Ankopplung aufgrund der großen Fläche und der geringen Schichtdicke der Isolationsschicht.

So kann der wenigstens eine Schaltungsträger eine kunststoffbasierte dielektrische Schicht umfassen. Dabei kann es sich insbesondere um eine innenliegende Schicht eines mehrschichtigen Schaltungsträgers handeln, welche sandwichartig von elektrisch leitfähigen Schichten und insbesondere von Dickschicht-Leiterbahnen umgeben ist. Ein solcher Schaltungsträger mit einer Polyimid-basierten dielektrischen Schicht ist beispielsweise von der Firma Dupont unter dem Namen ODBC (für "organic direct-bond copper"-Substrat) erhältlich. Solche organischen Dickkupfer-Substrate weisen im Vergleich zu Schaltungsträgern mit keramischen dielektrischen Schichten den Vorteil auf, dass die organische Schicht mechanische Spannungen aufgrund der hohen Leiterbahn-Dicken sehr viel besser ausgleichen kann als eine keramische Schicht. Hierdurch ist es möglich, Leiterbahnen mit den genannten hohen Schichtdicken einzusetzen, ohne dass es beim Betrieb zu spannungsbedingten Brüchen oder Rissen im Schaltungsträger kommt. Die dielektrische Schicht muss nicht ausschließlich aus einem organischen Kunststoff bestehen, kann aber vorteilhaft auf einem solchen Material basieren. Es kann sich insbesondere aus einem Verbundmaterial aus einem organischen Polymer und ein oder mehreren weiteren Bestandteilen handeln.

Gemäß einer alternativen vorteilhaften Ausführungsform kann der wenigstens eine Schaltungsträger auch durch einen metallischen Leadframe gebildet sein. Auch hier kann es sich wiederum besonders bevorzugt um einen kupfer-basierten Leadframe handeln. Unter einem Leadframe wird hierbei ein sogenannter Anschlussrahmen verstanden, also ein lötbarer metallischer Leitungsträger in Form eines Rahmens oder Kamms. Die Struktur eines solchen Leadframes kann insbesondere durch Stanzen oder Laserbearbeitung erzeugt sein. Der Leadframe kann insbesondere einen flächigen Anbindungsbereich für den jeweiligen Halbleiterchip und einen weiteren flächigen Anbindungsbereich für die weitere thermische Anbindung an den zugeordneten Kühlkörper aufweisen. Auch hier liegen jedenfalls dicke Leiterbahnen in Form der einzelnen Stege vor, welche neben der elektrischen Anbindung auch eine Entwärmung des zugeordneten Halbleiterchips mit einem Entwärmungspfad innerhalb der Baugruppen-Ebene bewirken. Zur elektrischen Isolation zwischen dem Kühlkörper und dem Halbleiterchip kann auch ein solcher Leadframe zumindest im Bereich der Anbindungsstelle für den Kühlkörper mit einer entsprechenden elektrisch isolierenden Schicht versehen sein.

Auch für den Aufbau der einzelnen Schichten der Elektronik-Baugruppe und insbesondere die Anzahl und Abfolge der einzelnen Schichten sowie die Zahl der darin vorhandenen Teilelemente sind unterschiedliche vorteilhafte Ausführungsvarianten möglich.

So kann allgemein vorteilhaft der wenigstens eine Halbleiterchip auf einer ersten Oberfläche mit einem ersten Schaltungsträger flächig verbunden sein und auf einer zweiten, gegenüberliegenden Oberfläche mit einem zweiten Schaltungsträger oder mit einem metallischen Blech flächig verbunden sein. Mit anderen Worten ist dann der Schaltungsträger sandwichartig zwischen zwei thermisch leitfähige Strukturen eingebettet, die jeweils eine Entwärmung mit einer Haupt-Entwärmungsrichtung innerhalb der Baugruppen-Ebene bewirken. Mit dieser Ausführungsform wird daher eine besonders effektive beidseitige Entwärmung des Halbleiterchips erreicht, wobei auf beiden Seiten der Weitertransport der Wärme parallel zur Chip-Ebene erfolgt. Selbstverständlich können auch mehrere solche Halbleiter-Chips in entsprechender Weise sandwichartig zwischen zwei solche wärmeleitende Elemente eingebettet sein.

Bei dieser Ausführungsform mit einer sandwichartigen Einbettung des Halbleiterchips ist es besonders vorteilhaft, wenn der Abstand zwischen dem ersten Schaltungsträger und dem zweiten Schaltungsträger bzw. dem metallischen Blech wenigstens 5 µm beträgt. Besonders vorteilhaft kann dieser Abstand in einem Bereich zwischen 25 µm und 400 µm liegen. Dieser Abstand ist hoch genug, um eine ausreichend hohe Durchschlagfestigkeit zwischen den gegenüberliegenden metallischen Elementen zu gewährleisten und gering genug, um eine ausreichend gute beidseitige thermische Ankopplung des Halbleiterchips zu ermöglichen.

Weiterhin ist es bei dieser Ausführungsform besonders vorteilhaft, wenn der Zwischenraum zwischen dem ersten Schaltungsträger und dem zweiten Schaltungsträger bzw. dem metallischen Blech mit einem elektrisch isolierenden Füllstoff aufgefüllt ist. Hierdurch können Spannungsüberschläge vorteilhaft vermieden werden, und es können auch mechanische Spannungen zwischen den einzelnen Elementen ausgeglichen werden. Als Materialien können hier vorteilhaft silikon-basierte Materialien, typische Underfill-Materialien und Moldmassen wie z.B. Globtop zum Einsatz kommen. Optional kann ein solches Polymermaterial wiederum mit einem Füllstoff gefüllt sein, um einen vorgegebenen Wert für den thermischen Expansionskoeffizienten einzustellen und auf diese Weise thermisch induzierte Spannungen zwischen dem Halbleiterchip und den Schaltungsträgern bzw. dem metallischen Blech vorteilhaft gering zu halten.

Alternativ oder zusätzlich zu der beschriebenen sandwichartigen Einbettung des Halbleiterchips kann zumindest ein innenliegender Schaltungsträger auf jeder seiner Hauptflächen mit einem oder mehreren zugehörigen Halbleiterchips flächig verbunden sein. Auf diese Weise ergibt sich auch bezüglich des innenliegenden Schaltungsträgers ein sandwichartiger Aufbau. Diese Ausführungsform kann besonders vorteilhaft mit der vorhergehenden kombiniert werden, so dass insgesamt zwei Ebenen von Halbleiterchips vorliegen, welche jeweils beidseitig (durch einen gemeinsamen innenliegenden Schaltungsträger und einen separaten außenliegenden Schaltungsträger) entwärmt werden. Diese Big-Mac-artige Struktur aus insgesamt wenigstens fünf Schichten kann insbesondere im Wesentlichen symmetrisch bezüglich des innenliegenden Schaltungsträgers aufgebaut sein.

Besonders vorteilhaft ist es bei dieser Ausführungsform, wenn sich der innenliegende Schaltungsträger in Richtung des ersten Randbereichs der Elektronik-Baugruppe in seinem Querschnitt verdickt. Auf diese Weise kann die thermische Anbindung des innenliegenden Schaltungsträgers an den dort vorliegenden Kühlkörper noch weiter verbessert werden. So kann der innenliegende Schaltungsträger beispielsweise ein T-förmiges Profil aufweisen, wobei die thermische Anbindung an den Kühlkörper im Bereich des Querbalkens des T-Profils realisiert ist.

Gemäß einer weiteren allgemein vorteilhaften Ausführungsvariante kann der Kühlkörper in wenigstens zwei mechanisch getrennte Teilelemente aufgeteilt sein. Die Trennlinie zwischen diesen Teilelementen kann insbesondere zentral durch die Hauptebene der Baugruppe verlaufen. Insbesondere bei dem vorab beschriebenen sandwichartigen Schichtaufbau kann dann jeder Hälfte des Sandwichs ein eigenes Teilelement des Kühlkörpers zugeordnet sein. Auf diese Weise können thermisch induzierte mechanische Spannungen im Bereich des Kühlkörpers (bzw. zwischen diesem und den benachbarten Elementen) wirksam reduziert sein.

Alternativ oder zusätzlich ist es aber auch möglich, den Kühlkörper so aufzuteilen, dass eine Trennlinie senkrecht zu der Hauptebene der Baugruppe verläuft. Insbesondere kann der Kühlkörper so in ein Kopfelement und ein weiteres Element mit zwei Seitenteilen aufgeteilt sein, wobei das Kopfelement im ersten Randbereich angeordnet ist und sich die Seitenteile parallel zur Hauptebene erstrecken und die übrigen Elemente des Schichtaufbaus gewissermaßen einhüllen.

Allgemein und unabhängig vom genauen Aufbau und des Kühlkörpers kann auch ein Zwischenraum zwischen dem Kühlkörper und der wenigstens einen Dickschicht-Leiterbahn mit einem Füllstoff aufgefüllt sein. Alternativ oder zusätzlich können auch noch weitere Maßnahmen zur mechanischen Entkopplung innerhalb der Baugruppe zum Einsatz kommen, beispielsweise durch Metallschäume als Füllstoff, durch Federn zwischen den einzelnen Elementen sowie auch durch Verzweigungen zwischen den einzelnen Dickschicht-Leiterbahnen oder die Ausbildung eines Stapels, bei dem die Gesamtdicke einer Dickschicht-Leiterbahn aus mehreren Teilschichten zusammengesetzt ist.

Gemäß einer beispielhaften Ausführungsform der Vorrichtung kann der Grundträger parallel zur Rückwand eines Schaltschranks verlaufen oder auch durch diese Rückwand selbst gegeben sein. Entsprechend kann es sich bei der Vorrichtung um eine Schaltvorrichtung und/oder um eine Steuervorrichtung handeln, welche insbesondere zur Steuerung eines elektrischen Antriebs ausgelegt sein kann. Beispielsweise kann es sich um eine Steuervorrichtung für eine industrielle Anwendung, insbesondere für eine industrielle Fertigungsanlage handeln, welche ein oder mehrere erfindungsgemäße Elektronik-Baugruppen aufweist. Bei den einzelnen Elektronik-Baugruppen kann es sich zumindest teilweise bevorzugt um Leistungsmodule handeln, die zum modularen Einbau in die Einbauebene der Vorrichtung vorgesehen sind, beispielsweise um Umrichter-Module. Hierzu kann die jeweilige Elektronik-Baugruppe entsprechende Verbindungselemente aufweisen, beispielsweise steckbare Pins zum Einstecken in einen Steckplatz auf dem Grundträger. Zusätzlich zu den bereits beschriebenen Elementen kann die übergeordnete Vorrichtung optional auch eine Kühlvorrichtung, ein Gehäuse und/oder ein oder mehrere Stromschienen aufweisen.

Nachfolgend wird die Erfindung anhand einiger bevorzugter Ausführungsbeispiele unter Bezugnahme auf die angehängten Zeichnungen beschrieben, in denen:
- Figur 1: eine schematische Schnittdarstellung einer Elektronik-Baugruppe nach dem Stand der Technik zeigt,
- Figur 2: eine Elektronik-Baugruppe nach einem ersten Beispiel der Erfindung im schematischen Längsschnitt zeigt,
- Figur 3: eine Aufsicht auf eine innere Dickschicht-Leiterbahn der Figur 2 zeigt,
- Figuren 4 und 5: schematische Längsschnitte von Elektronik-Baugruppen nach weiteren Beispielen der Erfindung zeigen,
- Figur 6: eine Aufsicht auf den dritten Schaltungsträger der Figur 5 zeigt und
- Figuren 7 bis 9: weitere Varianten für den Aufbau des Kühlkörpers in solchen Elektronik-Baugruppen zeigen.

In den Figuren sind gleiche oder funktionsgleiche Elemente mit gleichen Bezugszeichen versehen.

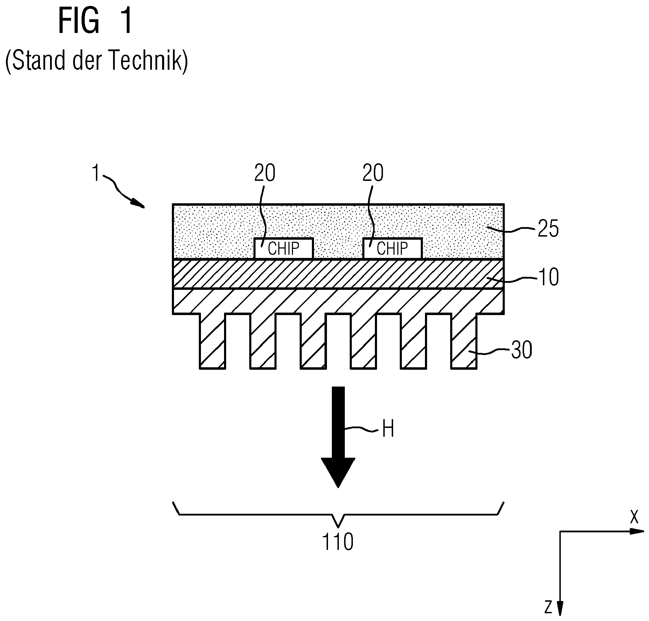

In Figur 1 ist eine schematische Schnittdarstellung einer Elektronik-Baugruppe nach dem Stand der Technik gezeigt, welche typisch für den grundsätzlichen Aufbau gängiger leistungselektronischer Baugruppen ist. So sind hier zwei Halbleiterchips 20 flächig mit einem Schaltungsträger 10 verbunden und auf ihrer Außenseite mit einem Vergussmittel 25 vergossen. Der Schaltungsträger 10 ist auf seiner gegenüberliegenden Hauptfläche mit einem Kühlkörper 30 verbunden, der Kühlrippen zur Abfuhr von Wärme an die äußere Umgebung aufweist. Dadurch ist insgesamt eine flächige Elektronik-Baugruppe 1 gegeben, deren Hauptebene hier innerhalb der xy-Ebene liegt. Die Richtung des Haupt-Entwärmungspfades H liegt senkrecht zu dieser Ebene, also in z-Richtung. Um eine Entwärmung zu einer nach außen offenliegenden Seite zu gewährleisten, wird eine solche Baugruppe nach dem Stand der Technik flach in einen Einbauplatz 110 einer übergeordneten Vorrichtung eingebaut. Mit anderen Worten liegt die Einbauebene dann auch innerhalb der xy-Ebene, und der Haupt-Entwärmungspfad H ist im Wesentlichen senkrecht zur Einbauebene orientiert. Hierdurch entsteht ein relativ großer lateraler Flächenbedarf für den Einbauplatz 110 in der xy-Ebene. Die Größe des benötigten Einbauplatzes ist typischerweise sogar noch größer als die laterale Abmessung der hier gezeigten Elemente, weil meist noch zusätzlicher Platz innerhalb der xy-Ebene für die hier der Übersichtlichkeit halber nicht näher dargestellten Lastanschlüsse und Steuerleitungen vorgesehen werden muss. Insgesamt benötigt damit ein solches horizontal aufgebautes Elektronik-Modul sehr viel Bauraum innerhalb der Einbauebene einer übergeordneten Vorrichtung.

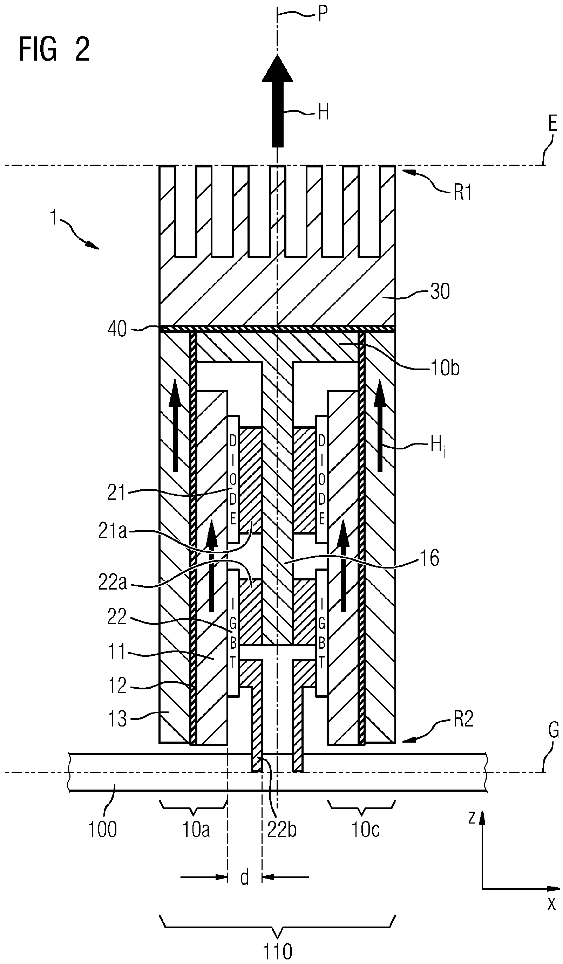

In Figur 2 ist eine Elektronik-Baugruppe 1 nach einem ersten Beispiel der Erfindung gezeigt. Gezeigt ist ein schematischer Längsschnitt, der senkrecht zu einer Hauptebene P der insgesamt flächig ausgebildeten Elektronik-Baugruppe verläuft. Die gezeigt Elektronik-Baugruppe umfasst drei Schaltungsträger 10a, 10b und 10c, welche jeweils mit ihren Hauptflächen parallel zu der Hauptebene P liegen. Sie liegen sandwichartig übereinander. Die beiden äußeren Schaltungsträger 10a und 10c sind jeweils mit zwei Halbleiterchips bestückt, nämlich in diesem Beispiel jeweils mit einer Leistungsdiode 21 und einem IGBT 22. Die beiden äußeren Schaltungsträger 10a und 10c sind in diesem Beispiel aus mehrschichtigen Dickkupfer-Substraten gebildet. Sie weisen also Dickschicht-Leiterbahnen 11 und 13 aus Kupfer auf, wobei prinzipiell auch andere metallische Materialien für die Dickschicht-Leiterbahnen zum Einsatz kommen können. Die Dicke der einzelnen Leiterbahnen in x-Richtung kann dabei insbesondere wenigstens 1 mm betragen. Jeder der beiden Schaltungsträger 10a und 10c weist in diesem Beispiel eine innere 11 und eine äußere Dickschicht-Lage 13 auf und dazwischen eine organische dielektrische Schicht 12. Der Schaltungsträger-Aufbau kann insgesamt ähnlich wie bei den sogenannten ODBC-Substraten von Dupont ausgestaltet sein. Die beiden Halbleiterchips 21,22 auf jedem Schaltungsträger 10a bzw. 10c sind also auf einer innenliegenden Dickschicht-Leiterbahn 11 angeordnet und mit dieser z.B. durch Löten, Sintern, Diffusionslöten oder Kleben verbunden. Dadurch ist zum einen ein elektrischer Kontakt hergestellt und zum anderen eine thermische Anbindung vermittelt. Im gezeigten Beispiel sind die Leistungsdiode 21 und der zugehörige IGBT 22 durch die jeweilige innere Dickschicht-Leiterbahn 11 nach Art einer Common-Emitter-Schaltung verbunden. Die übrigen Kontakte des IGBT sind mit zugehörigen Anschlusselementen 22b verbunden, von denen in der hier nicht gezeigten y-Richtung jeweils zwei hintereinander angeordnet sind und die als Pins zum Einstecken in eine übergeordnete Vorrichtung ausgestaltet sein können. Der zweite Kontakt der jeweiligen Leistungsdiode 21 ist über ein Verbindungselement 21a mit einer zentralen Dickschichtleiterbahn 16 des innenliegenden zweiten Schaltungsträgers 10b verbunden. Auch die IGBTs 22 sind über zugehörige Verbindungselemente 22a an die zentrale Dickschicht-leiterbahn 16 angekoppelt.

Auf diese Weise sind alle vier Halbleiterchips 20, 21 thermisch an die parallel zur Hauptebene P verlaufenden Dickschicht-Leiterbahnen 11 und 16 angekoppelt. Die inneren Dickschicht-Leiterbahnen 11 sind wiederum über die dünne dielektrische Schicht des jeweiligen Schaltungsträgers thermisch an die jeweilige äußere Dickschicht-Leiterbahn 13 angekoppelt. So kann durch die gute thermische Leitfähigkeit ein Wärmetransport in z-Richtung erreicht werden, und die beim Betrieb der Halbleiterchips erzeugte Verlustwärme kann in Richtung des ersten Randbereichs R1 der Baugruppe abgeführt werden. In diesem ersten Randbereich R1 ist ein Kühlkörper 30 angeordnet. Dieser Kühlkörper weist z.B. eine Mehrzahl von Kühlrippen auf, die ebenfalls parallel zur Hauptebene verlaufen können. Die (einhüllende) Außenfläche des Kühlkörpers stellt eine Entwärmungsfläche E dar, durch die ein Haupt-Entwärmungspfad H für die Abführung von Wärme an die äußeren Umgebung hindurchtritt. Insgesamt liegt dieser Haupt-Entwärmungspfad im Wesentlichen parallel zur Hauptebene P der Baugruppe. Dies wird dadurch erreicht, dass die Wärme durch die Dickschicht-Leiterbahnen 11, 13 und 16 in z-Richtung von den Bereichen der jeweiligen Halbleiterchips zum Kühlkörper hin transportiert wird. Es ergeben sich somit mehrere Teilpfade Hᵢ, die innerhalb der einzelnen Dick-Schichtleiterbahnen und jeweils im Wesentlichen in z-Richtung verlaufen. Somit ergibt sich eine Netto-Entwärmungsrichtung parallel zur Hauptebene. Dabei soll allerdings nicht ausgeschlossen sein, dass lokal auch ein Wärmeübertritt in x-Richtung stattfindet, z.B. wenn die Wärme von dem jeweiligen Halbleiterchip 21,22 in die benachbarte Dickschichtleiterbahn 11 bzw. 16 abgeführt wird oder wenn sie von der inneren Dickschichtleiterbahn 11 über die dielektrische Schicht 12 in die benachbarte äußere Dickschichtleiterbahn 13 weitergeleitet wird.

Wesentlich ist im Zusammenhang mit der vorliegenden Erfindung, dass die Netto-Entwärmungsrichtung H parallel zur Hauptebene P verläuft. Hierdurch wird erreicht, dass die Elektronik-Baugruppe hochkant, also mit einer Anbindung in ihrem schmalen zweiten Randbereich R2 in eine übergeordnete Vorrichtung eingebaut werden kann. Nur äußerst schematisch ist in Figur 2 ein Teil eines Grundträgers 100 gezeigt, welcher Teil einer übergeordneten Vorrichtung ist und einen Einbauplatz 110 für die Baugruppe 1 aufweist. Durch die beschriebene Hochkant-Anordnung wird erreicht, dass der Einbauplatz 110 innerhalb der in der xy-Ebene verlaufenden Einbauebene G nur eine relativ geringe laterale Fläche benötigt. Trotzdem wird durch die beschriebene Entwärmung in z-Richtung, die über die Dickschicht-Leiterbahnen vermittelt wird, ein Wärmetransport weg vom Grundkörper und damit eine effektive Entwärmung an die äußere Umgebung erreicht. Die Verbindung mit dem Grundträger 100 kann beispielsweise durch ein Einstecken der Pins 22b erreicht werden.

Beim Beispiel der Figur 2 sind mehrere Halbleiterchips 21, 22 nach Art eines mehrschichtigen Sandwichs zwischen insgesamt drei Schaltungsträgern 10a, 10b, 10c eingebettet. Dies ist aber nicht unbedingt nötig, um die Vorteile der Erfindung zu verwirklichen. Wesentlich ist nur, dass zumindest für einen Halbleiterchip mit wenigstens einer Dickschichtleiterbahn eines zugehörigen Schaltungsträgers ein Wärmetransport parallel zur Baugruppen-Ebene und somit weg vom Einbauplatz 110 in der übergeordneten Vorrichtung erreicht wird.

Der sandwichartige Aufbau beim Beispiel der Figur 2 bringt den Vorteil mit sich, dass die einzelnen Halbleiterchips durch ihre beidseitige Ankopplung an die benachbarten Dickschicht-Leiterbahnen 11, 16 noch effektiver entwärmt werden können. Dabei beträgt der Abstand d zwischen diesen gegenüberliegenden Dickschicht-Leiterbahnen 11 und 16 vorteilhaft wenigstens 10 µm, so dass Spannungsüberschläge vermieden werden. Der gebildete Zwischenraum kann optional mit einem hier nicht gezeigten elektrisch isolierenden Füllstoff aufgefüllt werden.

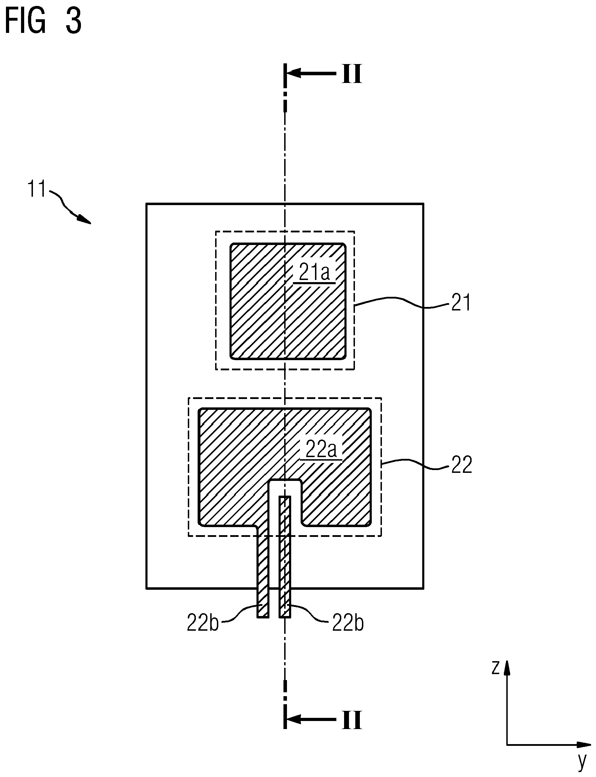

In Figur 3 ist eine der inneren Dickschicht-Leiterbahnen 11 aus dem Beispiel der Figur 2 mit der darauf angeordneten Leistungs-Diode 21 und dem IGBT 22 in schematischer Aufsicht gezeigt. Außerdem ist die Lage der zugehörigen Verbindungselemente 21a, 22a zur Anbindung an die zentrale Dickschicht-Leiterbahn und der zusätzlichen Anschlusselemente 22b des IGBT angedeutet. Die Schnittlinie II-II entspricht dabei der Position des Querschnitts der Figur 2. In diesem Beispiel sind die beiden Halbleiterchips 21, 22 in z-Richtung benachbart angeordnet, so dass sie bezüglich des Haupt-Entwärmungspfades hintereinander liegen.

Die Anordnung von diesen beiden Halbleiterchips auf dem gemeinsamen Schaltungsträger 10a ist nur beispielhaft zu verstehen. Es können auch andere Topologien und Verschaltungen von anderen Arten und Anzahlen von Chips zum Einsatz kommen, wobei auch mehrere Chips gestapelt werden können und zusätzliche Leiterbahnen vorliegen können. Es können auch mehrlagige Leiterbahnen eingesetzt werden, um einen niederinduktiven Aufbau zu erreichen. Optional kann auch eine elektrische Durchkontaktierung durch das Halbleitermaterial in Form von Vias vorliegen, um die elektrische Anbindung der Chips zu erleichtern.

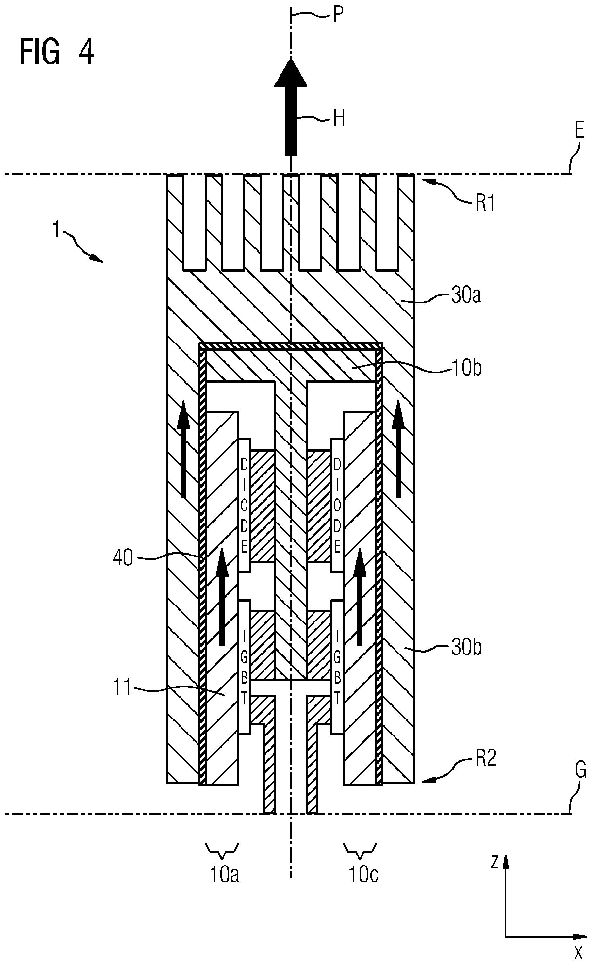

Figur 4 zeigt eine Elektronik-Baugruppe 1 nach einem weiteren Beispiel der Erfindung im schematischen Längsschnitt. Die grundlegende Anordnung der Halbleiterchips 21, 22 und ihre Einbettung zwischen insgesamt drei Schaltungsträger 10a, 10b, 10c ist ähnlich wie beim Beispiel der Figur 2. Im Interschied dazu sind die beiden außenliegenden Schaltungsträger 10a und 10c hier im Wesentlichen durch das Material der Dickschicht-Leiterbahnen 11 gebildet. Sie können also z.B. als Kupfer-Leadframes ausgestaltet sein. Anstelle der außenliegenden Dickschicht-Leiterbahnen aus der Figur 2 weist hier der Kühlkörper zusätzlich zu dem aus Figur 2 weitgehend übernommenen Kopfteil 30a noch zwei flächige Seitenteile 30b auf, die sich parallel zu den Dickschicht-Leiterbahnen 11 erstrecken. Der Wärmetransport zwischen den Dickschicht-Leiterbahnen 11 und den Seitenteilen 30b des Kühlkörpers wird hier durch eine Isolationsschicht 40 vermittelt, so dass der Kühlkörper von den Leiterbahnen elektrisch isoliert ist. Aufgrund der großen Fläche und der geringen Schichtdicke der Isolationsschicht 40 wird trotzdem eine gute thermische Anbindung an die Seitenelemente des Kühlkörpers und damit wiederum ein effektiver Haupt-Entwärmungspfad H parallel zur Hauptebene P der Baugruppe erreicht.

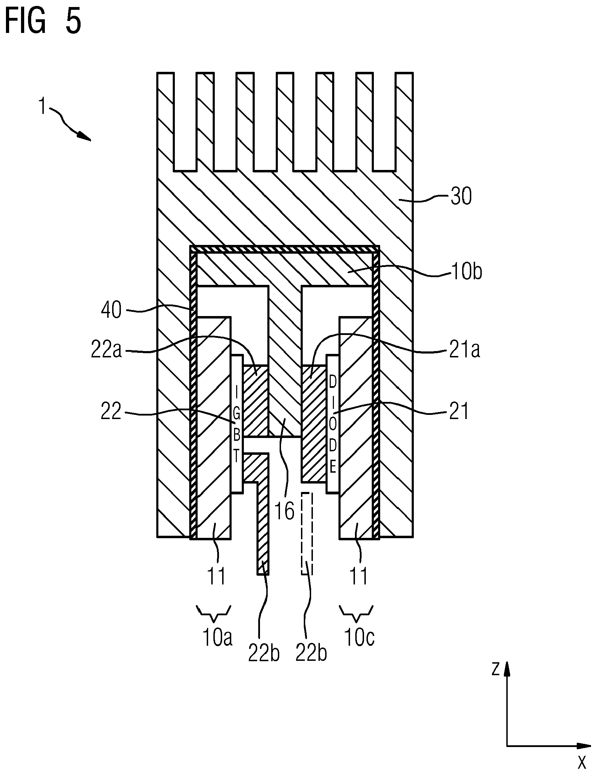

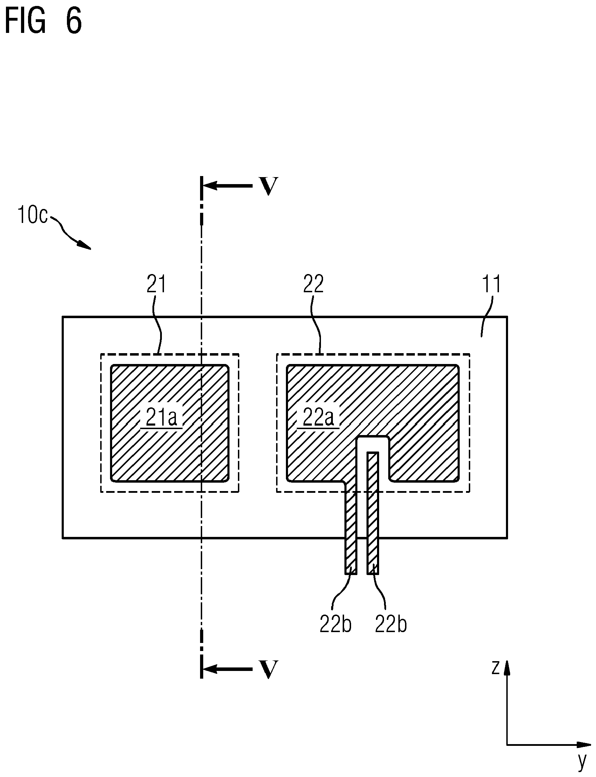

Figur 5 zeigt eine Elektronik-Baugruppe 1 nach einem weiteren Beispiel der Erfindung im schematischen Längsschnitt. Der Schichtaufbau der Baugruppe und auch der Aufbau des Kühlkörpers sind ähnlich wie beim vorhergehenden Beispiel der Figur 4. Auch hier ist jeder der beiden Schaltungsträger 10a und 10c mit einer Leistungs-Diode 21 und einem IGBT 22 bestückt, wobei diese beiden Bauelemente jedoch hier in der nicht dargestellten y-Richtung benachbart angeordnet sind, so dass in der Schnittdarstellung der Figur 5 jeweils nur ein Bauelement pro Schaltungsträger sichtbar ist. Die Aufsichtsdarstellung der Figur 6 verdeutlicht, wie auf dem jeweiligen Schaltungsträger (hier zum Beispiel dem dritten Schaltungsträger 10c) die beiden Bauelemente 21 und 22 bezüglich der Haupt-Entwärmungsrichtung z nebeneinander angeordnet sind.

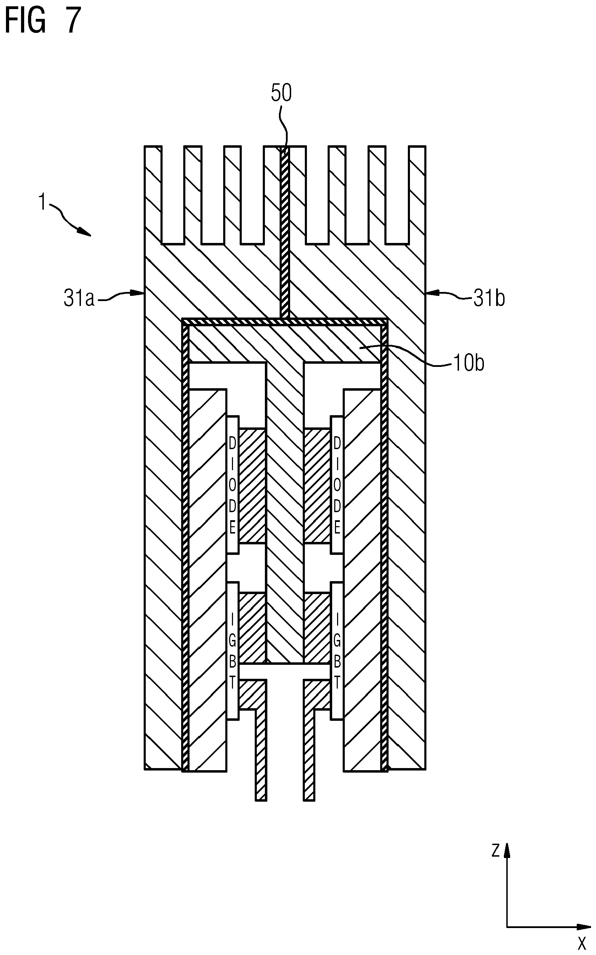

Figur 7 zeigt eine Elektronik-Baugruppe 1 nach einem weiteren Beispiel der Erfindung im schematischen Längsschnitt. Bei diesem Beispiel ist der Aufbau weitgehend ähnlich wie beim Beispiel der Figur 4. Der wesentliche Unterschied dazu ist, dass der Kühlkörper hier aus zwei Teilelementen 31a und 31b zusammengesetzt ist. Die Verbindung der beiden Teilelemente wird über eine Kopplungsschicht 50 vermittelt, die in der yz-Ebene liegt und geeignet ist, thermisch induzierte mechanische Spannungen zwischen den beiden Teilelementen zu reduzieren.

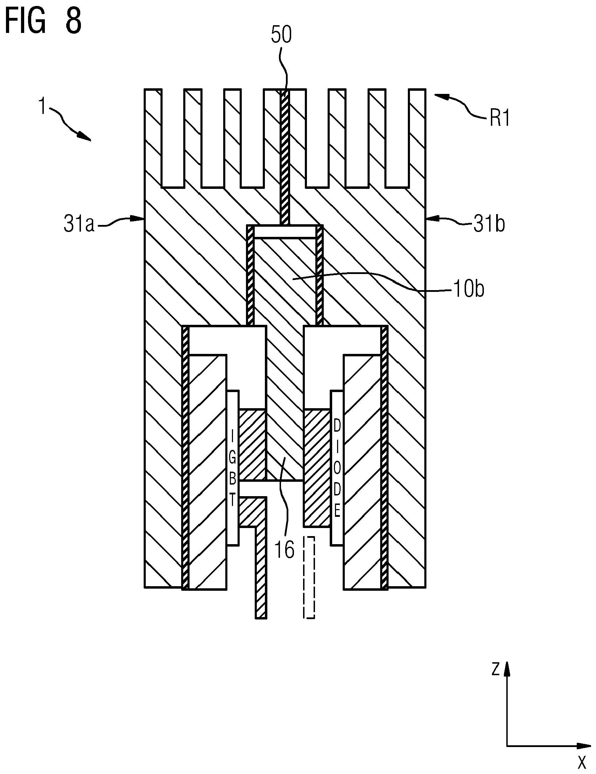

Figur 8 zeigt eine Elektronik-Baugruppe 1 nach einem weiteren Beispiel der Erfindung im schematischen Längsschnitt. Bei diesem Beispiel ist der Aufbau weitgehend ähnlich wie beim Beispiel der Figuren 5 und 6. Der wesentliche Unterschied ist, dass auch hier - ähnlich wie beim Beispiel der Figur 7 - der Kühlkörper aus zwei Teilelementen 31a und 31b zusammengesetzt ist. Im Unterschied zum Beispiel der Figur 7 ist hier der innenliegende zweite Schaltungsträger in Richtung des Kopfteils des Kühlkörpers nicht ganz so stark T-förmig verbreitert, sondern er ist hier zum Randbereich R1 hin nur leicht verdickt. Um eine gute thermische Ankopplung an die zentrale Dickschicht-Leiterbahn 16 zu erreichen, weisen daher die beiden Teilelemente des Kühlkörpers in diesem Bereich jeweils eine zusätzliche Stufe auf.

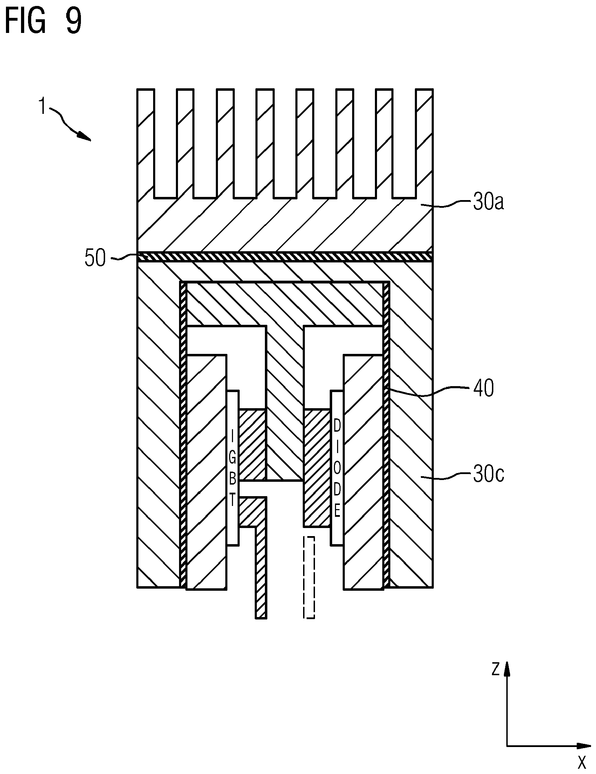

Figur 9 zeigt eine Elektronik-Baugruppe 1 nach einem weiteren Beispiel der Erfindung im schematischen Längsschnitt. Auch hier ist der Aufbau weitgehend ähnlich wie beim Beispiel der Figuren 5 und 6. Hier ist der Aufbau des Kühlkörpers in der Weise variiert, dass eine zusätzliche Aufteilung in ein Kopfteil 30a und ein davon separates Teilelement 30c vorliegt, wobei das Teilelement 30c ein U-förmiges Querschnittsprofil aufweist und die übrigen Elemente des Schichtaufbaus einhüllt. Die thermisch leitende Verbindung zwischen dem Teilelement 30c und dem Kopfteil 30a des Kühlkörpers ist hier durch eine Kopplungsschicht 50 aus einer Wärmeleitpaste realisiert. Die flächigen Seitenteile sind durch eine Isolationsschicht 40 mit den benachbarten Dickschicht-Leiterbahnen verbunden. Auch diese Art der Aufteilung des Kühlkörpers kann dazu beitragen, thermisch induzierte mechanische Spannungen innerhalb der Elektronik-Baugruppe 1 zu reduzieren.

Die verschiedenen gezeigten Ausführungsvarianten für die Anordnung der Halbleiterchips, den Aufbau der einzelnen Schaltungsträger und den Aufbau des Kühlkörpers können selbstverständlich untereinander kombiniert werden, und die Erfindung ist nicht auf die dargestellten Ausführungsbespiele beschränkt. Alle Beispiele verdeutlichen das allgemeine Konzept, wie durch die Schaffung eines effektiven EntwärmungsPfades innerhalb der Baugruppenebene ein platzsparender Hochkant-Einbau in einem kompakten Einbauplatz einer übergeordneten Vorrichtung ermöglicht wird.

### Bezugszeichenliste

- 1: Elektronik-Baugruppe
- 10: Schaltungsträger
- 10a: erster Schaltungsträger
- 10b: zweiter Schaltungsträger oder metallisches Blech
- 10c: dritter Schaltungsträger
- 11: innere Dickschicht-Leiterbahn
- 12: organische dielektrische Schicht
- 13: äußere Dickschicht-Leiterbahn
- 16: zentrale Dickschicht-Leiterbahn
- 20: Halbleiterchip
- 21: Leistungs-Diode
- 21a: Verbindungselement
- 22: IGBT
- 22a: Verbindungselement
- 22b: Anschlusselemente (Pins)
- 25: Vergussmittel
- 30: Kühlkörper
- 30a: Kopfteil
- 30b: flächiges Seitenteil
- 30c: U-förmiges Teilelement
- 31a: erstes Teilelement
- 31b: zweites Teilelement
- 40: Isolationsschicht
- 50: Kopplungsschicht
- 100: Grundträger
- 110: Einbauplatz
- d: Abstand
- E: Entwärmungsebene
- G: Einbauebene
- H: Haupt-Entwärmungspfad
- Hᵢ: Teilpfade
- P: Hauptebene der Elektronik-Baugruppe
- R1: erster Randbereich der Elektronik-Baugruppe
- R2: zweiter Randbereich
- x,y,z: kartesische Koordinaten

## Patentansprüche

1. Elektronik-Baugruppe (1) mit wenigstens einem Schaltungsträger (10a,10b,10c), wenigstens einem Halbleiterchip (20a,20b) und wenigstens einem Kühlkörper (30),
- wobei die Elektronik-Baugruppe (1) eine flächige Grundform mit einer Hauptebene (P) aufweist und insbesondere zum Einbau in eine übergeordnete Vorrichtung vorgesehen ist,
- wobei der wenigstens eine Schaltungsträger (10a,10b,10c) parallel zur Hauptebene (P) orientiert ist und einen oder mehrere Halbleiterchips (20a,20b) trägt, mit denen er flächig verbunden ist,
- wobei in einem ersten Randbereich (R1) der flächigen Elektronik-Baugruppe (1) der wenigstens eine Kühlkörper (30) angeordnet ist,
- und wobei der wenigstens eine Schaltungsträger (10a,10b,10c) zwischen dem Bereich des wenigstens einen Halbleiterchips (20a,20b) und dem ersten Randbereich (R1) wenigstens eine Dickschicht-Leiterbahn (11,13,16) aufweist, die Teil eines Haupt-Entwärmungspfades (H) ist, welcher im Wesentlichen parallel zur Hauptebene (P) verläuft.

2. Elektronik-Baugruppe (1) nach Anspruch 1, welche als leistungselektronische Baugruppe ausgebildet ist und wenigstens ein leistungselektronisches Bauelement als Halbleiterchip aufweist, insbesondere wenigstens eine Leistungs-Diode (21) und/oder ein IGBT (22).

3. Elektronik-Baugruppe (1) nach einem der Ansprüche 1 oder 2, welche mehrere Halbleiterchips (21,22) auf demselben Schaltungsträger (10a,10c) aufweist, welche bezüglich des Haupt-Entwärmungspfades (H) nebeneinander und/oder hintereinander angeordnet sind.

4. Elektronik-Baugruppe (1) nach einem der vorhergehenden Ansprüche, bei welcher die wenigstens eine Dickschicht-Leiterbahn (11,13,16) thermisch an den Kühlkörper (30) angekoppelt ist.

5. Elektronik-Baugruppe (1) nach Anspruch 4, bei welcher die thermische Anbindung von wenigstens einer Dickschicht-Leiterbahn (11,13,16) an den Kühlkörper durch eine großflächige Isolationsschicht (12,40) vermittelt wird.

6. Elektronik-Baugruppe (1) nach einem der vorhergehenden Ansprüche, bei welcher der wenigstens eine Schaltungsträger (10a,10c) eine dielektrische Schicht (12) aus einem elektrisch isolierenden Kunststoff umfasst.

7. Elektronik-Baugruppe (1) nach einem der Ansprüche 1 bis 5, bei welcher der wenigstens eine Schaltungsträger (10a,10b, 10c) durch einen metallischen Leadframe gebildet ist.

8. Elektronik-Baugruppe (1) nach einem der vorhergehenden Ansprüche, bei welcher der wenigstens eine Halbleiterchip (21,22) auf einer ersten Oberfläche mit einem ersten Schaltungsträger (10a) flächig verbunden ist und auf einer zweiten Oberfläche mit einem zweiten Schaltungsträger oder einem metallischen Blech (10b) flächig verbunden ist.

9. Elektronik-Baugruppe (1) nach Anspruch 8, bei welcher der Abstand (d) zwischen dem ersten Schaltungsträger (10a) und dem zweiten Schaltungsträger oder dem metallischen Blech (10b) wenigstens 5 µm beträgt.

10. Elektronik-Baugruppe (1) nach einem der Ansprüche 8 oder 9, bei welcher der Zwischenraum zwischen dem ersten Schaltungsträger (10a) und dem zweiten Schaltungsträger oder dem metallischen Blech (10b) und gegebenenfalls auch der Zwischenraum zwischen diesem und einem optionalen dritten Schaltungsträger (10c) mit einem elektrisch isolierenden Füllstoff aufgefüllt ist.

11. Elektronik-Baugruppe (1) nach einem der vorhergehenden Ansprüche, bei welcher wenigstens ein innenliegender Schaltungsträger (10b) auf jeder seiner beiden Hauptflächen mit einem oder mehreren zugehörigen Halbleiterchips (21,22) flächig verbunden ist, so dass sich ein sandwichartiger Aufbau ergibt.

12. Elektronik-Baugruppe (1) nach Anspruch 11, bei welcher sich der wenigstens eine innenliegende Schaltungsträger (10b) in Richtung des ersten Randbereichs (R1) der Elektronik-Baugruppe (1) in seinem Querschnitt verdickt.

13. Elektronik-Baugruppe (1) nach einem der vorhergehenden Ansprüche, bei welcher der Kühlkörper in wenigstens zwei mechanisch getrennte Teilelemente (31a,31b) aufgeteilt ist.

14. Elektronik-Baugruppe (1) nach einem der vorhergehenden Ansprüche, bei welchem ein Zwischenraum zwischen dem Kühlkörper (30) und der wenigstens einen Dickschicht-Leiterbahn (11,13,16) mit einem Füllstoff aufgefüllt ist.

15. Vorrichtung mit einem Grundträger (100) und wenigstens einer Elektronik-Baugruppe (1) nach einem der vorhergehenden Ansprüche,
- wobei durch den Grundträger (100) eine Einbauebene (G) definiert ist, von der ein Teilbereich als Einbauplatz (110) für die Elektronik-Baugruppe (1) ausgebildet ist,
- wobei die Elektronik-Baugruppe (1) derart von dem Grundträger (100) absteht, dass die Hauptebene (P) der Elektronik-Baugruppe (1) einen Winkel von wenigstens 30°, insbesondere etwa 90°, zur Einbauebene (G) des Grundträgers ausbildet.
